Europäisches Patentamt

European Patent Office

Office européen des brevets

(11) Publication number: **0 435 502 A1**

## (12) EUROPEAN PATENT APPLICATION

(21) Application number: 90313404.7

(22) Date of filing: 10.12.90

(51) Int. Cl.⁵: **C08G 8/24**, G03F 7/023, C08G 8/08

(30) Priority: 18.12.89 US 452027

(43) Date of publication of application:
03.07.91 Bulletin 91/27

(84) Designated Contracting States:
AT BE CH DE DK ES FR GB GR IT LI LU NL SE

(71) Applicant: ROHM AND HAAS COMPANY
Independence Mall West
Philadelphia Pennsylvania 19105 (US)

(72) Inventor: Bogan, Leonard Edward, Jr.
325 Moyer Road
Harleysville, Pennsylvania 19438 (US)

(74) Representative: Tanner, James Percival et al
ROHM AND HAAS (UK) LTD. European
Operations Patent Department Lennig House
2 Mason's Avenue
Croydon, Surrey, CR9 3NB (GB)

(54) Method of preparing high glass transition temperature novolak resins useful in high resolution photoresist compositions.

(57) Novolak resins which possess a high glass transition temperature ("Tg"), and which are particularly suited for use in high resolution photoresist compositions, are provided. The resins are prepared by the condensation reaction of formaldehyde with multi-substituted phenol, for example 3,5-dimethyl phenol, resorcinol compound, and, optionally, another phenol. Novolak resins having Tg's greater than about 120 degrees Centigrade are preferred.

## METHOD OF PREPARING HIGH GLASS TRANSITION TEMPERATURE NOVOLAK RESINS USEFUL IN HIGH RESOLUTION PHOTORESIST COMPOSITIONS

The present invention is concerned with novolak resins having high glass transition temperatures ("Tg"), for example, having Tg's greater than about 120 degrees Centigrade, and their use as a polymeric binder component in high resolution photoresist compositions. More particularly, the present invention is concerned with such resins which are formed by the condensation reaction of formaldehyde with at least one multi-substituted phenol, a resorcinol, and, optionally, another phenol.

In the process of making an integrated circuit, a photoresist composition is used to define an image pattern on a substrate surface.

Photoresist compositions are film-forming polymeric compositions typically containing at least one film-forming polymer and a photoactive compound dissolved in a suitable solvent. The photoresist composition is applied, as a film, onto a substrate surface, for example the surface of a silicon wafer such as in the preparation of an integrated circuit or computer chip. A photomask is positioned between the substrate surface containing the photoresist film and a source of exposing radiation. The photomask acts like a stencil having portions which are transparent to the exposing radiation to be used and other portions which are opaque to the exposing radiation. The photomask is designed and fabricated to duplicate the final pattern which is desired to be transferred onto the substrate, for example an electronic circuit pattern. The exposing radiation to be employed is typically radiation of a single wavelength, or narrow range of wavelengths, referred to as actinic radiation, in the visible or shorter wavelength spectra, for example ultraviolet, x-rays, or electron beams. Portions of the photoresist film are exposed to the selected exposing radiation through the photomask at a predetermined dosage and time. Through the proper positioning of the photomask relative to the photoresist film only those portions of the photoresist film juxtaposed with the transparent portions of the photomask are exposed to the actinic radiation. The exposing radiation is absorbed by the photoactive compound in the photoresist film. This causes a chemical reaction in the exposed portions of the film. In the case of a positive-acting photoresist this Chemical reaction renders the exposed portions of the photoresist film more soluble than the unexposed portions of the film to certain selected solutions known as developers. This differential solubility, between the exposed and unexposed portions of the photoresist film, to such developers, permits the selective removal of the exposed portions of the film in a development step thereby leaving the unexposed portions of the photoresist film on the substrate after development. This creates a pattern either for the subsequent deposition of a conductive metal, insulator or dopant, or for etching the substrate, in the portions of the substrate not protected by the remaining photoresist portions. These remaining photoresist portions are subsequently removed from the substrate using selected stripping solvents.

After the photoresist film has been selectively exposed and developed, but before the final stripping step, the remaining portions of the photoresist film must be able to withstand the rigors of subsequent processing conditions without significant physical changes. For example, the photoresist film may be subjected, during these processing steps, to temperatures in excess of its flow point, for example in the case of plasma etching. If such high temperature conditions cause the photoresist to flow then the desired final resolution of the photoresist pattern will become degraded. Resolution is a term used to define either the distance between adjacent photoresist features or spaces, or the width of an isolated feature, in the final photoresist pattern.

A negative-acting photoresist operates in a similar manner to a positive-acting photoresist, the primary difference being that the portions of the photoresist film which are selectively exposed to actinic radiation become less soluble in the developer solution than the unexposed portions of the photoresist film. Therefore, in the case of a negative-acting photoresist, the developer solution is employed to remove the unexposed portions of the photoresist film after exposure. Because of this difference, if one were to use the same photomask for processing a negative-acting photoresist as used to process a positive-acting photoresist, the image which would be created on the substrate after development would be the inverse or "negative" of the image created by processing the positive photoresist. In some instances, for example in the case of an acid-hardening, negative-acting photoresist, the exposed portions of the photoresist are crosslinked after the development and removal of the unexposed portions of the photoresist film.

The glass transition temperature of conventional novolak resins typically used in positive-acting photoresists is approximately 100 degrees Centigrade. Conventional positive-acting novolak-containing photoresists typically produce images having resolution of about 1.0 to about 1.5 micrometers. Due to the desire to reduce the size of electronic components there is a need for higher resolution photoresists, preferably photoresists which can be processed using the same equipment and processes as currently employed but which produce photoresist image patterns having resolution of approximately 1 micrometer or less.

Increasing the glass transition temperature of the polymeric binder component of a positive-acting photoresist would appear to be the solution to the thermal flow and resolution degradation problems limiting commercial positive-acting novolak-containing photoresists. However, while it is desirable to increase the Tg of the novolak, such a change must not b accompanied with :

(i) a substantial reduction in the dissolution rate difference between the exposed and unexposed portions of the film upon development, particularly when using aqueous developer solutions ;

(ii) a significant change in the film formation characteristics and film properties of the resist, for example the ability of the unexposed portions to be as resistant as possible to the subsequent chemicals and conditions used in the subsequent processing ;

(iii) the performance of the photoresist, for example the resolution capability of the resist ; or

(iv) a limited ability to reproducibly manufacture the novolak itself and to formulate the photoresist composition.

A high $T_g$ novolak resin may also be useful as a component of the polymeric binder in a high resolution, negative acting photoresist composition.

Novolak polymers, as prepared by conventional synthesis techniques, are typically complex mixtures of polymers formed by the acid catalyzed condensation reaction of phenol with formaldehyde. This reaction proceeds in two steps : the first being the addition of formaldehyde to the unsubstituted ortho and/or para positions on the phenol ring. The second step involves the random joining of the methylol groups, previously added from the formaldehyde to the phenol ring during the first step, with unsubstituted ortho and/or para positions on phenol rings to form a mixture of random novolak polymers. For a detailed discussion of novolak resins and their preparation, see Phenolic Resins, A. Knop and L.A. Pilato, Chapter 3, Springer Verlag, N.Y. (1985).

The use of novolak resins in positive-tone photoresists is well known in the art as described in Thompson, L. F. ; Wilson, C. G. : Bowden, M. J. ; Introduction to Microlithopraphy, American Chemical Society, 1983 ; and Bowden, M. J. ; Turner, S R. ; Electronic and Photonic Applications of Polymers, American Chemical Society, 1988.

These novolak-containing, positive-acting photoresists do not, however, have high thermal stability.

Novolak resins have also been proposed for use as hardeners for epoxy resin compositions, for example in US-A-4,368,299. The use of novolak resins as hardeners for epoxy resin compositions involves different chemistry than the use of novolak resins in positive-tone photoresists. When used as hardeners, the novolak resins participate in a crosslinking reaction, making the composition less soluble. When used in conventional positive-tone photoresists, the novolak resins do not participate in the photoresist chemistry and exposure renders the resist composition more soluble.

US-A-4,376,854 teaches the preparation of novolak resins which may contain the same phenolic monomers used in the present invention, but which have their phenol and resorcinol components segregated in blocks, whereas in the present invention these monomers are distributed randomly throughout the polymer chains.

US-A-4,275,170 and US-A-4,309,527 teach the preparation of block copolymer novolaks made from two phenols and furfural, whereas the present invention involves the preparation of random copolymers or terpolymers made from two or three phenols and formaldehyde.

DD 211415 teaches the use in positive-tone photoresists of novolak resins which may contain the same phenolic monomers used in the present invention, but which have highly regular molecular structure and narrow molecular weight distribution, whereas the present invention involves the preparation of novolak resins with typically random stereochemistry of phenolic ring substitution and typically broad molecular weight distribution.

GB-A-2192636 teaches the use, in positive-tone photoresists, of novolak resins which may contain the same phenolic monomers used in the present invention, but which are substituted with ethylenically unsaturated groups, whereas the present invention involves the preparation of novolak resins without such ethylenically unsaturated groups.

Accordingly, a need remains for a novolak resin having a high glass transition temperature which can be used in photoresist compositions, and particularly in positive photoresist compositions, to provide high resolution.

Additionally, it is desirable that such a novolak resin be capable of being prepared in a reproducible manner, possess a controllable and reproducible dissolution rate behavior in conventional aqueous developer solutions, and otherwise be suitable for use in conventional photoresist formulations and processes.

According to the present invention there is provided a method for preparing a high glass transition temperature novolak, useful in high resolution photoresist compositions, which comprises conducting a condensation reaction between from about 30 to about 85 mole percent formaldehyde, from about 5 to about 95 mole percent multi-substituted phenol, and from about 95 to about 5 mole percent resorcinol compound.

Novolak resins possessing a high glass transition temperature ("Tg") for use in high resolution photoresist compositions, particularly in high resolution, positive-acting photoresist compositions, are provided. The resins are prepared by the condensation reaction of formaldehyde with multi-substituted phenol, resorcinol compound, and, optionally, another phenol. Novolak resins having Tg's greater than about 120 degrees Centigrade are preferred. These novolaks are preferably prepared by the condensation reaction of formaldehyde with multi-substituted phenol (eg 3,5-dimethylphenol), 2-methylresorcinol and m-cresol.

We have found that the condensation reaction of formaldehyde with a multi-substituted phenol, a resorcinol and, optionally, another phenol is useful for preparing a novolak resin having a glass transition temperature of at least about 120 degrees Centigrade and which is particularly suitable for use in high resolution positive-acting photoresists.

The resorcinol compound used in the reaction may be selected from resorcinol, 4-chlororesorcinol, 2-methylresorcinol, 4-methylresorcinol 4-ethylresorcinol, and alkyl or aryl substituted di-or tri-hydroxy benzenes. We have found that 2-methylresorcinol is the preferred resorcinol compound for use in preparing high Tg novolak resins for use in high resolution photoresists, for example high resolution positive photoresists, because of its solubility and reactivity characteristics.

The optional phenol is preferably meta-cresol, however, other phenols may be used. These other phenols include, for example, phenol, ortho-cresol, para-cresol, 2,3-dimethylphenol, and 2,5-dimethylphenol. Meta-cresol was found to be preferred because of its solubility and reactivity characteristics.

The term " multi- substituted phenol", as used herein, typically refers to a phenol or mixture of phenols where at least the 3 and 5 positions, and, optionally, in addition thereto, the 4,2 or 1 positions, are substituted with one or more of the following substituents : lower ($C_1$ to $C_6$) alkyl, and aryl groups, where each of said substituents are the same or different, for example 3,4,5-tri-alkyl or aryl phenol, or 3,5 di-alkyl or aryl phenol. The preferred multi-substituted phenol is 3,5-dimethylphenol.

The novolak resin is prepared from about 30 to about 85 mole percent formaldehyde, from about 5 to about 95 wt. percent multi-substituted phenol, from about 95 to about 5 wt. percent resorcinol, and from 0 to about 70 wt. percent of one, or more than one, other phenol.

The reaction may be conducted by adding a solution of the phenol or phenols, resorcinol and aqueous formaldehyde in solvent, for example bis-(methoxyethyl) ether, with a solution of an acid catalyst in solvent, for example oxalic acid in bis-(methoxyethyl) ether, to a heel charge in the reactor vessel of solvent and 5 weight percent of each of the above monomer and catalyst solutions over a period of several hours at a temperature of about 100 degrees C. After the addition of the monomer and catalyst solutions is complete, the reaction mixture is stirred at this temperature for about 30 minutes, and then the volatiles including solvent, unreacted monomer and catalyst, are removed from the reaction product by distillation. The distillation is typically accomplished in two steps ; first under nitrogen atmosphere and secondly under vacuum. The addition, together, of a mixture of phenol, or phenols, and resorcinol together, eg as described above, ensures that the sequence of the incorporation of the phenolic monomers in the resultant novolak polymer is random, and the addition of the formaldehyde with this mixture ensures that the resultant novolak polymer molecular weight distribution will be broad, as is conventionally the case for novolak polymers. This procedure and the resultant novolak polymer differs from that described in the prior art, for example in DD 211415, in which formaldehyde is reacted with one phenolic monomer with the resulting adduct being then reacted with the other monomer to produce a polymer having a regular, alternating sequence of monomers and a narrower molecular weight distribution.

The glass transition temperature of the resin is determined by Differential Scanning Calorimetry ("DSC"). This technique involves heating a sample under nitrogen to 200 degrees Centigrade, cooling the sample to 75 degrees Centigrade, and then heating the sample again at a rate of 10 degrees Centigrade per minute while monitoring the heat flow. The Tg is taken as the midpoint of the inflection in the heat flow versus temperature curve.

The glass transition temperature ("Tg") of the resin may be controlled by the selection of a number of variables, for example, the proportion of the optional phenol incorporated into the novolak resin, the ratio of the multi-substituted phenol to resorcinol in the resin, and the molecular weight of the novolak resin produced. Each of these variables contribute to the final Tg of the novolak resin. As the proportion of optional phenol is increased the Tg is decreased. As the proportion of multi-substituted phenol to resorcinol is increased the Tg is decreased. As the number average molecular weight ($M_n$) of the novolak resin increases the Tg of the resin is increased.

The dissolution rate of the novolak resin can be controlled independently of the Tg of novolak resin. The dissolution rate of the novolak resin is controlled by the relative proportions of resorcinol, multi-substituted phenol and optional phenol in the novolak resin, and the molecular weight of the novolak in order of decreasing effect. As the ratio of multi-substituted phenol to resorcinol is increased, the dissolution rate is decreased. As the amount of optional phenol is increased the dissolution rate of the novolak is increased or decreased depending upon the optional phenol chosen. As the molecular weight of the novolak is increased the dissolution rate of the novolak is decreased.

A critical aspect of preparing a novolak polymer for use in a photoresist composition is the batch-to-batch dissolution rate reproducibility of the polymer. Being able to reproduce the dissolution rate of the novolak resin is more important than reproducing the molecular weight of the novolak resin. Since the reactivities of phenolic monomers are known to vary greatly one from another (See Phenolic Resins, A.Knop and L.A. Pilato (1985)), reproducing a novolak resin having uniform dissolution rate behavior is not trivial. The variation in reactivity of phenolic monomers means that the composition of the polymeric novolak resin is a function of the extent of reaction of the monomers, which is difficult to control.

Our preference in selecting 3,5-dimethylphenol, 2-methylresorcinol and, optionally, meta-cresol is the result of their similar reactivities. This similarity permits the formation of a polymeric novolak resin composition which is very similar to the composition of the monomer feed over a wide range of monomer feed compositions and polymer molecular weights.

Typically the high Tg novolak resin should have a weight average molecular weight in the range of from about 3,000 to about 100,000, preferably in the range of from about 5,000 to about 80,000, and most preferably in the range of from about 10,000 to about 40,000, when employed in a positive-acting photoresist composition which is intended for use with aqueous developers.

The positive-acting photoresist compositions, utilizing the high Tg novolak resins as at least one component of the polymeric binder system, can contain from about 50 to about 98 weight percent of the polymeric binder, preferably from about 70 to about 95 weight percent on total solids. The remainder of the photoresist composition may comprise at least one photoactive compound, an optional dissolution rate inhibitor, such as 2,2- bis-$(4,4^1$ -tertiary-butoxycarbonyl oxyphenyl) propane, and at least one solvent. The concentration of the photoactive compound or compounds may be in the range of from about 2 to about 50, preferably from about 5 to 30 weight percent, on solids. The photoactive compound or compounds are usually neutral compounds or mixtures of compounds that are converted to an acid upon the exposure of portions of the photoresist film. The acid, which is generated, makes the polymeric binder in the exposed positive photoresist film portions, containing the high Tg novolak, more soluble or removable from the substrate surface by the action of the developer solution than the unexposed photoresist film portions. In the preferred embodiment wherein an aqueous solution is used as the developer for the positive photoresist film, it is preferred that the photoactive compound generate a carboxylic acid upon exposure to actinic radiation. Examples of suitable photoactive compounds include o-naphthoquinone diazides and polymers thereof as described in more detail in the following US Patents : 2,766,118 ; 2,767092 ; 3,046,118 ; 3,046,121 ; 3,046,123 ; 3,106,465 ; 3,148,983 ; 3,189,733 ; 3,201,239 ; 3,635,709 ; 3,640,992 ; 3,661,582 ; 3,666,473 ; 3,732,273 ; 3,759,711 ; 3,785,825 ; 3,890,152 ; and 4,308,368.

Other compounds which can generate carboxylic acids upon exposure to actinic radiation, for example o-nitrobenzyl esters and onium salts and derivatives thereof, and photosensitizers such as phenothiazine and derivatives thereof, may also be used in such positive-acting, aqueous developable photoresist compositions.

In negative-acting photoresists the acid generated in the exposed portions of the photoresist film is useful to cause a crosslinking reaction in the exposed photoresist portions rendering the relative dissolution between those portions and the unexposed portions even greater.

The solvents which can be used in formulating the photoresist compositions of the invention include : glycol ethers, for example ethylene glycol monomethylether,ethylene glycol monoethylether, Propasol B and P and the like ; Cellosolve esters, for example Cellosolve acetate, ethyl Cellosolve acetate, and the acetates of Propasol B and P and the like ; aromatic hydrocarbons, for example toluene, xylene, and the like ; ketones, for example methylethyl ketone, cyclopentanone, cyclohexanone, and the like ; esters, for example ethylacetate, butylacetate, isobutyl isobutyrate, butyrolactone, and the like ; amides, for example dimethylacetamide, N-methylpyrrolidone, dimethyl formamide and the like ; chlorinated hydrocarbons, for example ethylene dichloride, chlorobenzene, ortho-dichlorobenzene, and the like ; nitrobenzene ; dimethylsulfoxide ; and mixtures of the above. The photoresist composition typically contains at least about 50 percent by weight solvent, and preferably from about 65 to about 95 percent by weight solvent. The solvent or solvent mixture used, to apply the photoresist film onto the substrate surface, must not react adversely with the polymeric binder containing the novolak resin, or the photoactive compound or compounds in the photoresist composition. The coating formed therefrom must be of a homogeneous nature, free from sediment, crystallized components, particulates and dirt.

Various additives commonly employed in photoresist compositions may be used in the high Tg novolak-containing photoresist composition of the invention. These additives are typically employed in minor amounts ranging from about 0.001 to about 10 percent by weight of total solids. They are used to enhance the performance of the photoresist film, and may act as flow or leveling agents, anti-striation agents, plasticizers, compatibilizing agents, and anti-reflective dyes.

The photoresist composition of the invention may be used in a conventional manner, for example by : spin coating a photoresist film onto a substrate surface from the photoresist composition ; soft-baked or heated by using a hot plate to remove residual solvent and form a tack-free film ;exposed to actinic radiation, preferably in the visible,near or mid ultraviolet wavelength region, and most preferably at the most typically used actinic radiation of 436 nanometers, through a conventional photomask, and developed, in the case of a positive-acting photoresist, using conventional aqueous base developers, for example 0.27 N tetramethylammonium hydroxide.

We have found that positive-acting, photoresist compositions of the present invention are suitable for preparing high resolution images of approximately 1 micrometer and less utilizing conventional processing techniques designed for conventional novolak-containing positive photoresists.

The high glass transition temperature novolak polymers of the invention may also be employed as a polymeric binder component of negative-acting, photoresists which may be developed using conventional solvent solutions, such as non-polar organic solvents or solvent mixtures, for example dichloromethane, xylene, or mixtures thereof with 2-heptanone.

The following examples are presented to illustrate preferred embodiments of the present invention. Unless otherwise stated, all percentages are weight percentages.

### Example 1 : Preparation of High Tg novolaks

To a 1 liter, 4-neck round bottom flask, equipped with a C-stirrer, a thermometer, two addition funnels and a nitrogen inlet, was added 60 grams of diglyme. The diglyme was heated to 99 degrees Centigrade. A mixture of 36.2 % aqueous formaldehyde (137.5 grams, 1.66 moles), 135.7 grams (1.26 moles) m-cresol, 98.3 grams (0.80 moles) 3,5-dimethylphenol, 18.7 grams (0.15 moles) 2-methylresorcinol and 20 grams of diglyme were stirred and dissolved together and then charged to one of the addition funnels. 12.4 grams (0.0984 moles) oxalic acid dihydrate were dissolved in 82 grams diglyme and then charged to the other addition funnel. Aliquots of the monomer solution (20.5 grams, 5%) and the catalyst solution (4.7 grams, 5%) were added to the flask. The solutions remaining in the addition funnels were added to the flask over a period of 180 minutes. After the addition was completed, the solution in the flask was stirred at reflux for 30 minutes and then the condenser was replaced with a sidearm, a condenser, and a receiver for the distillate. Volatiles were removed by distillation under a nitrogen sweep. When the temperature of the reaction solution reached 180 degrees Centigrade, distillation was continued under vacuum (10 mmHg) until a final temperature and pressure of from about 215 to 250 degrees Centigrade and 10 mmHg had been maintained for 30 minutes. The flask was then cooled in dry ice and the vacuum was broken with nitrogen.

The product was analyzed by [13]Carbon NMR spectoscopy and found to be 54% m-cresol, 39% 3,5-dimethylphenol and 7% 2-methylresorcinol, on a molar basis. Analysis by gel permeation Chromatography indicated the product had a weight average molecular weight of 27,200 daltons and a number average molecular weight of 1460 daltons. The $T_g$ of the resin was determined by differential scanning calorimetry to be 138 degrees C.

### Example 2 : Photoresist Formulation

A positive-acting photresist composition was prepared by dissolving 57.07 grams of the novolak resin, prepared in Example 1, with 15.45 grams naphtoquinone diazide sulfonate ester (photoactive compound) and 0.8 grams of Fluorad (leveling agent) in a solvent mixture of 204.03 grams ethyl lactate, 11.34 grams xylene, and 11.34 grams n-butyl acetate.

### Example 3 : Photoresist Processing and Thermal Stability of Resist

The photoresist composition of Example 2 was applied as a 1.2 micrometer thick film on a silicon substrate by spin casting at 3,000 rpm. The photoresist film was exposed to actinic radiation at 436 nanometers through a positive photomask using a GCA6300 stepper exposure tool equipped with a 0.38 numerical aperture lens. The exposed portions of the photoresist film were removed using 0.27 N (aqueous) tetramethyl ammonium hydroxide developer. The resolution of the photoresist was measured by SEM and was found to be 0.7 micrometers (lines and spaces). The flow temperature of the resist image was determined by heating the resist image and then observing the edges of the resist image of a 5 micrometer pad by scanning electron microscopy. The pad began to deform at 135 degrees Centigrade.

### Example 4

This Example demonstrates the effect of feed and novolak resin composition and molecular weight on the dissolution rate and Tg of the novolak resin in aqueous base developers.

| Sample | Feed Composition (wt%) Cresol/3.5-DMP[5]/2-MR[6] | Novolak Plymr. Comp. (wt%) Cresol/3.5-DMP/2-MR | $M_w/M_n$[1] | Tg[2] | Diss. Rate |
|---|---|---|---|---|---|
| 2 | 95/5/0 | 95/5/0 | 8990/1030 | 89°C | -- |
| 3 | 75/25/0 | 82/18/0 | 22100/1110 | 80 | -- |
| 4 | 67/33/0 | 59/41/0 | 35500/1410 | 127 | -- |
| 5 | 27/37/36 | 39/34/27 | 6520/1300 | 142 | 2670 [3] |
| 6 | 27/37/36 | 38/31/31 | 4550/1110 | 129 | -- |
| 7 | 55/36/9 | 55/36/9 | 19300/1370 | 136 | 401 [3] |
| 8 | 57/38/5 | 59/35/6 | 54900/1570 | 138 | 12 [4] |
| 9 | 57/36/7 | 54/39/7 | 27200/1460 | 138 | 208 [4] |
| 10 | 40/50/10 | 39/50/11 | | 144 | 33 [4] |

1) As measured by GPC

2) As determined by DSC inflection point

3) Å/sec in 0.135 N Tetra methyl ammonium hydroxide (aq) (TMAH)

4) Å/sec in 0.27 N TMAH(aq)

5) 3,5-dimethyl phenol

6) 2-methyl resorcinol

The following are trademarks :
Cellosolve
Propasol

## Claims

1. A method for preparing a high glass transition temperature novolak, useful in high resolution photoresist compositions, which comprises conducting a condensation reaction between from about 30 to about 85 mole percent formaldehyde, from about 5 to about 95 mole percent multi-substituted phenol, and from about 95 to about 5 mole percent resorcinol compound.

2. The method of claim 1 wherein said condensation reaction is conducted in the presence of an acid catalyst, eg oxalic acid.

3. The method of claim 1 or claim 2 wherein said novolak polymer has a glass transition temperature of at least about 120 degrees C.

4. A method as claimed in any preceding claim, wherein said multi-substituted phenol comprises at least one phenol in which at least the 3 and 5 positions are substituted with an alkyl group containing from 1 to 6 carbon atoms or an aryl group and where said substituents on said 3 and said 5 positions are the same or different from each other.

5. A method as claimed in claim 4 wherein said multi-substituted phenol is 3,5-dimethylphenol.

6. A method as claimed in any preceding claim, wherein said resorcinol compound is selected from resorcinol, 4-chlororesorcinol, 2-methylresorcinol, 4-methylresorcinol, 4-ethylresorcinol, and alkyl or aryl substituted di-or tri- hydroxy benzene.

7. A method as claimed in any preceding claim, wherein said condensation reaction further comprises the use of a further phenol compound, for example meta-cresol.

8. A method for preparing a novolak resin, having a glass transition temperature of at least 120 degrees C., useful in a high resolution photoresist, which comprises conducting a condensation reaction between formaldehyde, 3,5-dimethylphenol, 2-methylresorcinol, and optionally, meta-cresol.

9. A high resolution photoresist composition, which comprises a novolak resin, prepared by a method as claimed in any of claims 1 to 8, and a photoactive compound in a non-reacting solvent.

10. A high resolution photoresist composition as claimed in claim 9 which is a positive-acting, aqueous developable photoresist.

11. A high glass transition temperature novolak, which comprises from about 30 to about 85 mole perent of units derived from formaldehyde, from about 5 to about 95 mole percent of units derived from multi-substituted phenol, from about 95 to about 5 mole percent of units derived from resorcinol compound, and, optionally, units derived from further phenol compound.

12. A high glass transition temperature novolak obtainable by a method as Claimed in any of Claims 1 to 8.

European Patent
Office

**EUROPEAN SEARCH REPORT**

Application Number

EP    90 31 3404

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-227487 (JAPAN SYNTHETIC RUBBER CO., LTD.) *Example 18* | 1-4, 6 | C08G8/24 G03F7/023 C08G8/08 |
| D,A | GB-A-2192636 (TOKYO OHKA KOGYO CO LTD) | | |
| A | WO-A-8904849 (OLIN HUNT SPECIALTY PRODUCTS INC.) | | |
| A | EP-A-287212 (MITSUBISHI CHEMICAL INDUSTRIES LIMITED) | | |
| D,A | DD-A-211415 (VEB FOTOCHEMISCHE WERKE BERLIN) | | |

TECHNICAL FIELDS
SEARCHED (Int. Cl.5)

C08G
G03F

The present search report has been drawn up for all claims

| Place of search | Date of completion of the search | Examiner |
|---|---|---|
| THE HAGUE | 01 FEBRUARY 1991 | PAULSSON R.L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document